# EUROPEAN PATENT APPLICATION

(11) **EP 4 425 898 A1**
(43) Date of publication of application: **04.09.2024**
(21) Application number: 22885771.0
(22) Date of filing: 19.10.2022
(51) Int. Cl.: H04L 69/04, H03M 7/30

(54) **THREE MODE-BASED DATA COMPRESSION METHOD AND DATA DECOMPRESSION METHOD**

(30) Priority: 29.10.2021 CN 202111273357
(71) Applicant: Shenzhen Zhi Hui Lin Network Technology Co., Ltd., Shenzhen, Guangdong 518000 (CN)
(72) Inventor: MOGHADDAM SARDROUD, Behzad, Shenzhen, Guangdong 518000 (CN); KALANTARI, Hamed, Shenzhen, Guangdong 518000 (CN); KALANTARI, Behzad, Shenzhen, Guangdong 518000 (CN); DING, Xiaoduan, Shenzhen, Guangdong 518000 (CN); HUANG, Kun, Shenzhen, Guangdong 518000 (CN); YIN, Yan, Shenzhen, Guangdong 518000 (CN)
(74) Representative: Hamer, Christopher K.
(86) International application number: PCT/CN2022/126266
(87) International publication number: WO 2023/071893

(57) **Abstract**

The disclosure provides a method data compression and a method for data decompression based on three data patterns. The method for data compression includes the following. Original data is acquired. A binary conversion is performed on the original data to obtain binary data. The binary data is split into multiple data splits, where each of the multiple data splits includes three different data patterns. The multiple data splits are abbreviated to obtain multiple abbreviated data splits. Abbreviated data is sent, where the abbreviated data includes the multiple abbreviated data splits. In the method for data compression provided in embodiments of the disclosure, after binary conversion, splitting, and abbreviation, the original data is compressed into the abbreviated data including multiple abbreviated data splits, where each of the multiple abbreviated data splits includes three different data patterns. In this way, the data transmission volume is greatly reduced, and the efficiency of data transmission is improved.

## Description

This application claims priority to Chinese Patent Application No. 202111273357.3, filed October 29, 2021 to China national intellectual property administration (CNIPA), and entitled "METHOD FOR DATA COMPRESSION BASED ON THREE DATA PATTERNS AND METHOD FOR DATA DECOMPRESSION BASED ON THREE DATA PATTERNS", the entire disclosure of which is hereby incorporated by reference.

### TECHNICAL FIELD

The present disclosure relates to the field of data processing technology, in particular, to a method for data compression based on three data patterns and a method for data decompression based on three data patterns.

### BACKGROUND

With the rapid development of our society and economy, and the continuous improvement of people's living standard, data communication technology has been widely popularized and applied in all walks of life. With the growth of data transmission volume, there is an increasingly high requirement for the speed of data transmission on the market.

In order to improve the speed of data transmission, data is usually split to achieve the purpose of compressing the data. As for current methods for data compression, data is usually split into multiple data splits with the same size for data transmission. However, in this method, the multiple data splits can only be further compressed through traditional compression algorithms, which will generate new compression redundancy. In addition, a certain amount of time is needed for the hard disk to index a large number of data splits, resulting in a decrease in the speed of data transmission. Therefore, with those current methods for data compression, the speed of data transmission is difficult to be improved.

### SUMMARY

Embodiments of the disclosure provide a method for data compression based on three data patterns and a method for data decompression based on three data patterns. The method for data compression provided in embodiments of the disclosure can improve the speed of data transmission by compressing original data.

In a first aspect, embodiments of the disclosure provide a method for data compression based on three data patterns. The method includes the following. Original data is acquired. A binary conversion is performed on the original data to obtain binary data. The binary data is split into multiple data splits, where each of the multiple data splits includes three different data patterns. The multiple data splits are abbreviated to obtain multiple abbreviated data splits. Abbreviated data is sent, where the abbreviated data includes the multiple abbreviated data splits.

In a possible embodiment, the above method further includes the following. A first sub-split is determined from a (first) abbreviated data split, where the first sub-split includes a first abbreviated result and a second abbreviated result of the abbreviated data split. Whether the first sub-split is the same as a third data pattern is detected. The abbreviated data split is abbreviated again to obtain a further abbreviated data split if the first sub-split is the same as the third data pattern.

In a second aspect, embodiments of the disclosure provide a method for data decompression based on three data patterns. The method includes the following. Abbreviated data is received, where the abbreviated data includes multiple abbreviated data splits, and each of the multiple data splits consists of two different abbreviated results and a marked data pattern. The multiple abbreviated data splits are restored to obtain multiple restored data splits, where each of the multiple restored data splits includes three different data patterns. The multiple restored data splits are spliced to obtain binary data.

In a third aspect, embodiments of the disclosure provide a data compression apparatus based on three data patterns. The apparatus includes an acquiring unit, a conversing unit, a splitting unit, an abbreviating unit, and a sending unit. The acquiring unit is configured to acquire original data. The conversing unit is configured to perform a binary conversion on the original data to obtain binary data. The splitting unit is configured to split the binary data into multiple data splits, where each of the multiple data splits includes three different data patterns. The abbreviating unit is configured to abbreviate the multiple data splits to obtain multiple abbreviated data splits. The sending unit is configured to send abbreviated data, where the abbreviated data includes the multiple abbreviated data splits.

In a fourth aspect, embodiments of the disclosure provide an electronic device. The electronic device includes a processor, a memory, and a computer-executable instruction that is stored in the memory and executable on the processor. The computer-executable instruction, when executed, causes the electronic device to execute some or all of the steps in any method in the first aspect.

In a fifth aspect, embodiments of the disclosure provide a computer-readable storage medium. The computer-readable storage medium stores a computer instruction, and the computer instruction, when executed on a communication device, causes the communication device to execute some or all of the steps in any of the method in the first aspect.

In a sixth aspect, embodiments of the disclosure provide a computer program product. The computer program product includes a computer program, which is operable to cause a computer to perform some or all of the steps in any method in the first aspect. The computer program product may be a software installation package.

It may be seen that, in embodiments of the disclosure, the original data is acquired; the binary conversion is performed on the original data to obtain the binary data; the binary data is split into the multiple data splits, where each of the multiple data splits includes three different data patterns; the multiple data splits are abbreviated to obtain the multiple abbreviated data splits; the abbreviated data is sent, where the abbreviated data includes the multiple abbreviated data splits. In the method for data compression provided in embodiments of the disclosure, after binary conversion, splitting, and abbreviation, the original data is compressed into the abbreviated data including multiple abbreviated data splits, where each of the multiple abbreviated data splits includes three different data patterns. In this way, the data transmission volume is greatly reduced, and the efficiency of data transmission is improved.

### BRIEF DESCRIPTION OF THE DRAWINGS

In order to describe technical solutions in the related art or embodiments of the disclosure more clearly, the following will give a brief introduction to the accompanying drawings required for describing the related art or embodiments. Apparently, the accompanying drawings hereinafter described are merely some embodiments of the disclosure. Based on these drawings, those of ordinary skills in the art can also obtain other drawings without creative effort.
FIG. 1A is a structural arrangement diagram of a data transmission system.
FIG. 1B is a flowchart of a method for data compression based on three data patterns provided in an embodiment of the disclosure.
FIG. 1C is an arrangement diagram of a system for data compression based on three data patterns applied by an embodiment of the disclosure.
FIG. 1D is a schematic diagram of a method for data compression based on three data patterns provided in an embodiment of the disclosure.
FIG. 1E is a schematic diagram of a method for data compression based on three data patterns provided in another embodiment of the disclosure.
FIG. 1F is a schematic diagram of a method for data compression based on three data patterns provided in another embodiment of the disclosure.
FIG. 2 is a flowchart of a method for data decompression based on three data patterns provided in an embodiment of the disclosure.
FIG. 3 is a structural diagram of an apparatus for data compression based on three data patterns provided in an embodiment of the disclosure.
FIG. 4 is a schematic structural diagram of a server serving as hardware operating environment of an electronic device provided in an embodiment of the disclosure.

### DETAILED DESCRIPTION

The following will illustrate technical solutions of embodiments of the disclosure with reference to the accompanying drawings of embodiments of the disclosure. Apparently, embodiments described herein are merely some embodiments, rather than all embodiments, of the disclosure. Based on the embodiments of the disclosure, all other embodiments obtained by those of ordinary skills in the art without creative effort shall fall within the protection scope of the disclosure.

The terms "first", "second", and the like used in the specification, the claims, and the accompany drawings of the disclosure are used to distinguish different objects rather than describe a particular order. In addition, the terms "include", "comprise", as well as variations thereof are intended to cover non-exclusive inclusion. For example, a process, a method, a system, a product, or a device that includes a series of steps or units is not limited to the listed steps or units, but optionally further includes an unlisted step or unit, or optionally further includes another step or unit inherent to the process, the method, the product, or the device.

Reference herein to an "embodiment" means that particular features, structures, or characteristics described in connection with embodiments may be included in at least an embodiment of the present disclosure. The phrase appearing in various positions in the specification does not necessarily refer to the same embodiment, nor is it an independent or alternative embodiment that is mutually exclusive with other embodiments. Those of ordinary skills in the art explicitly and implicitly understand that the embodiments described in present disclosure can be combined with other embodiments.

The following will introduce the application scenarios involved in embodiments of the disclosure with reference to the accompanying drawings.

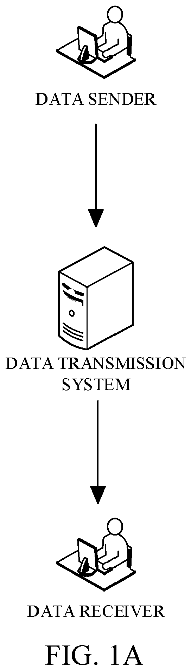

FIG. 1A is a structural arrangement diagram of a data transmission system. As illustrated in FIG. 1A, a first end of the system is connected to a data sender, and a second end of the system is connected to a data receiver.

The data sender is a role that sends the original data to the data transmission system to compress for the purpose of sending the original data to the data receiver.

The data transmission system is configured to receive the original data from the data sender, and split the original data into multiple data splits with the same size for data transmission, thereby sending the original data from the data sender to the data receiver.

The data receiver is a role that receives the multiple data splits from the data transmission system and restores the multiple data splits to obtain the original data.

In the process of data transmission by the above system, the original data is just split into multiple data splits with the same size and the multiple data splits is further compressed through traditional compression algorithms, which will generate new compression redundancy. In addition, a certain amount of time is needed for the hard disk to index a large number of data splits. It may be seen that the above process does not make enough improvement on the speed of data transmission.

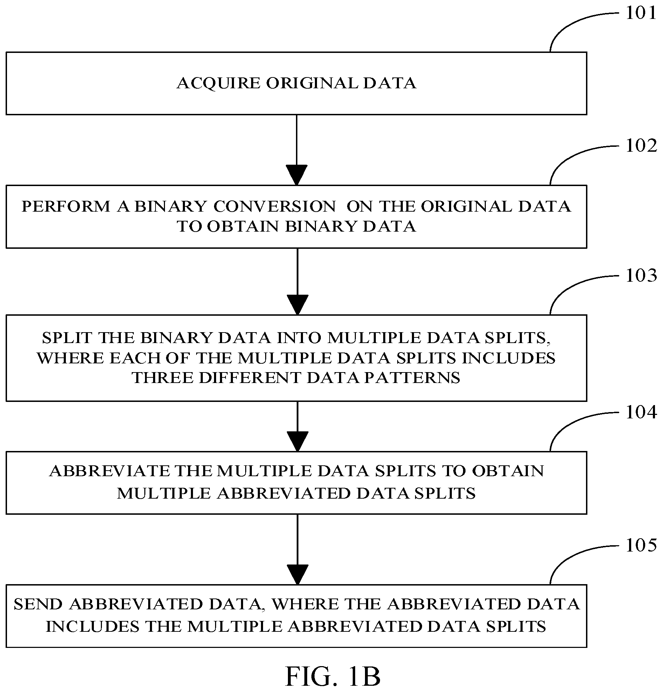

Therefore, embodiments of the disclosure provide a method for data compression based on three data patterns. Reference is made to FIG. 1B, which is a flowchart of a method for data compression based on three data patterns provided in an embodiment of the disclosure. As illustrated in FIG. 1B, the method includes the following operations.

At 101, original data is acquired.

The original data may be in a format of numerical value, text, image, sound, etc.

At 102, a binary conversion is performed on the original data to obtain binary data.

In specific embodiments, the binary conversion is performed on the original data as follows. The binary conversion may be performed on different types of original data through program codes such as JavaScript, C#, and the like.

The binary data includes two binary symbols, namely 0 and 1.

Exemplarily, the original data is a numerical value 5. A binary conversion is performed on the numerical value 5 to obtain binary data 0101.

At 103, the binary data is split into multiple data splits, where each of the multiple data splits includes three different data patterns.

Data patterns may include n-bit data, and the n-bit data included in a data pattern is different from n-bit data in another data pattern for the purpose of representing different data contents. In specific embodiments, in terms of splitting the binary data into multiple data splits, the binary data may be split into multiple data patterns with n-bit data as a unit, and then the binary data is split into the multiple data splits, where each of the multiple data splits is ensured to include three different data patterns.

Exemplarily, data patterns include two-bit data. If a data split is 000110, 00 of the data split 000110 is a first data pattern, 01 is a second data pattern, and 10 is a third data pattern, according to that data patterns include two-bit data. That is, 000110 includes three data patterns, namely 00, 01, and 10.

Each of the multiple data splits includes three different data patterns, such that by ensuring that each data split only has three data patterns, it can be ensured that each data split has a certain length and the data complexity of each data split is reduced.

At 104, the multiple data splits are abbreviated to obtain multiple abbreviated data splits.

In specific embodiments, the multiple data splits may be abbreviated as follows. Each of the multiple data splits may be abbreviated according to the content of each data split. Each of the multiple data splits may also be abbreviated by abbreviating data patterns according to the content of each of the three different data patterns included in each data split.

Exemplarily, there are three data splits 1100, 0011, 1111, and each data pattern is assumed to include four-bit data. That is, each of the above three data splits is abbreviated according to the content of each data split. Since the content of each data split is different from an another, the data split 1100 may be abbreviated into 00, the data split 0011 may be abbreviated into 01, the data split 1111 may be abbreviated into 10, such that the abbreviation of these three data splits is complete. Alternatively, each data pattern is assumed to include two-bit data. If the data patterns are abbreviated according to the content of each data pattern of two different data patterns included in each data split, since the content of each data pattern is different from one another, the data pattern 11 may be abbreviated into 1 and the data pattern 00 may be abbreviated into 0. In this way, the data split 1100 is abbreviated into 10, the data split 0011 is abbreviated into 01, the data split 1111 is abbreviated into 11, such that the abbreviation of these three data splits is complete.

Exemplarily, each data pattern is assumed to include two-bit data, and the multiple data splits may also be abbreviated as follows. For each of the multiple data splits, a first type of data pattern is abbreviated into 1, a second type of data pattern is abbreviated into 0, and a third type of data pattern is marked. That is, for a data split 110001, 11 is abbreviated into 1, 00 is abbreviated into 0, 01 is marked, such that an abbreviated data split is 10(01). For a data split 100100, 10 is abbreviated into 1, 01 is abbreviated into 0, 00 is marked, such that an abbreviated data split is 10(00). For a data split 111000, 11 is abbreviated into 1, 10 is abbreviated into 0, 00 is marked, such that an abbreviated data split is 10(00). In this way, the abbreviation of the above three data splits is complete. The abbreviating manner adopted in the above example is applicable in the case where only two types of data, namely, 0 and 1, are desired to be included in the abbreviated data, and each abbreviated data split is desired to has a certain length in order to reduce the number of abbreviated data splits, so as to avoid a reduction in the speed of data transmission caused by that the hard disk needs to spend time indexing a large number of data splits.

It should be noted that, the above embodiments only serve as examples of abbreviating multiple data splits. In specific embodiments, multiple data splits may be abbreviated in other manners, which will not be limited herein.

At 105, abbreviated data is sent, where the abbreviated data includes the multiple abbreviated data splits.

In specific embodiments, the abbreviated data may consist of multiple abbreviated data splits that are spliced together in order.

The following will introduce devices involved in embodiments of the disclosure with reference to the accompanying drawings.

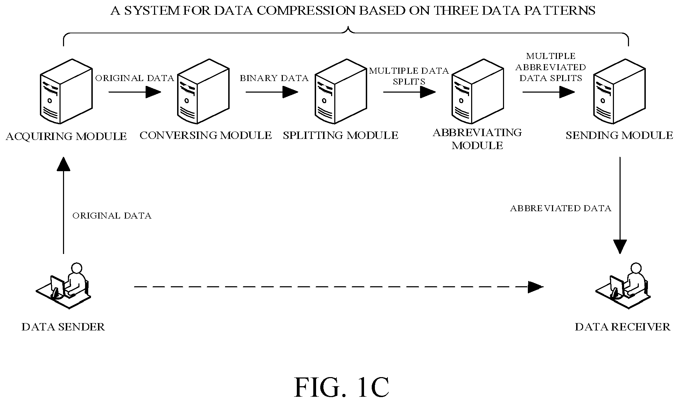

Reference is made to FIG. 1C, which is an arrangement diagram of a system for data compression based on three data patterns applied by an embodiment of the disclosure. As illustrated in FIG. 1C, the system includes an acquiring module, a conversing module, a splitting module, an abbreviating module, and a sending module. A first end of the system is connected to the data sender and a second end is connected to the data receiver. The functions of different modules may be realized by different servers or the functions of multiple modules may be realized by one server. Servers realizing the functions of different modules are communicatively connected to each other. The server may be an independent server or a cloud server that provides basic cloud computing services such as cloud services, a cloud database, cloud computing, cloud functions, cloud storage, network services, cloud communications, middleware services, domain name services, security services, a content delivery network (CDN), and a big data and artificial intelligence platform.

The data sender is a role that sends the original data to the acquiring module of the data transmission system based on three data patterns, for the purpose of sending the original data to the data receiver.

The acquiring module is configured to receive the original data from the data sender and send the original data to the conversing module.

The conversing module is configured to, after receiving the original data from the acquiring module, perform a binary conversion on the original data to obtain binary data, and send the binary data to the splitting module.

The splitting module is configured to, after receiving the binary data from the conversing module, split the binary data into multiple data splits, where each of the multiple data splits includes three different data patterns, and send the multiple data splits to the abbreviating module.

The abbreviating module is configured to, after receiving the multiple data splits from the splitting module, abbreviate the multiple data splits to obtain multiple abbreviated data splits, and send the multiple abbreviated data splits to the sending module.

The sending module is configured to, after receiving the multiple abbreviated data splits from the abbreviating module, splice the multiple abbreviated data splits to obtain abbreviated data, and send the abbreviated data including the multiple abbreviated data splits to the data receiver.

The data receiver is a role that receives the abbreviated data from the system for data compression based on three data patterns, and restore the abbreviated data to obtain the original data sent by the data sender.

Exemplarily, each data pattern is assumed to include two-bit data, and the multiple data splits are abbreviated in the following manner. For each of the multiple data splits, a first type of data pattern is abbreviated into 1, a second type of data pattern is abbreviated into 0, and a third type of data pattern is marked. Original data is acquired, and then a binary conversion is performed on the original data to obtain binary data 110010011110. The binary data 110010011110 is split in a manner that each data pattern includes two-bit data, to obtain six data patterns, namely 11, 00, 10, 01, 11, and 10. Under the premise of ensuring that each data split includes three different data patterns, the six data patterns are partitioned to obtain two data splits, namely 110010 and 011110. The two data splits are abbreviated. For the data split 110010, 11 is abbreviated into 1, 00 is abbreviated into 0, 10 is marked, such that an abbreviated data split 10(10) is obtained. For the data split 011110, 01 is abbreviated into 1, 11 is abbreviated into 0, 10 is marked, such that an abbreviated data split 10(10) is obtained. The two abbreviated data splits are then spliced to obtain abbreviated data 10(10)10(10). It may be seen that the data volume of the abbreviated data is greatly reduced compared to the binary data, which is beneficial for improving the speed of data transmission.

It may be seen that, in the embodiment of the disclosure, the original data is acquired; the binary conversion is performed on the original data to obtain the binary data; the binary data is split into the multiple data splits, where each of the multiple data splits includes three different data patterns; the multiple data splits are abbreviated to obtain the multiple abbreviated data splits; the abbreviated data is sent, where the abbreviated data includes the multiple abbreviated data splits. In the method for data compression provided in embodiments of the disclosure, after binary conversion, splitting, and abbreviation, the original data is compressed into the abbreviated data including multiple abbreviated data splits, where each of the multiple abbreviated data splits includes three different data patterns. In this way, the data transmission volume is greatly reduced, and the efficiency of data transmission is improved.

In a possible embodiment, the binary data is split into the multiple data splits as follows. The binary data is split to obtain multiple data patterns, where each of the multiple data patterns includes n-bit data. The multiple data patterns are partitioned to obtain multiple data splits, where each of the multiple data splits includes three data patterns.

N may be 2, 3, or other figures.

Each of the multiple data splits includes three different data patterns, so as to reduce the data complexity of each data split by ensuring that each data split has and only has three data patterns. At the same time, the number of data splits is reduced by ensuring that each data split has a certain length, thereby avoiding a reduction in the speed of data transmission caused by that the hard disk needs to spend time indexing a large number of data splits.

Exemplarily, n=2, that is, each data pattern includes two-bit data. If binary data is 110010011110, the binary data is split in a manner that each data pattern includes two-bit data to obtain six data patterns, namely 11, 00, 10, 01, 11, 10. The six data patterns are partitioned in a manner that each data split includes three data patterns to obtain two data splits, namely 110010 and 011110. It may be seen that each data split includes three data patterns and each data pattern includes two-bit data.

It may be seen that, in the embodiment of the disclosure, the binary data is split in a manner that each data pattern includes n-bit data to obtain the multiple data patterns. The multiple data patterns are partitioned in a manner that each data split includes three data patterns to obtain the multiple data splits. In this way, each of the multiple data splits is ensured to include three data patterns, which greatly reduces the data complexity of each data split and ensures that each data split has a certain length. By simplifying the content of each data split and reducing the number of data splits, the speed of data transmission is improved.

In a possible embodiment, the multiple data patterns are partitioned to obtain the multiple data splits as follows. The multiple data patterns are scanned, and a first data pattern and a second data pattern that are read are partitioned into a first data split. A third data pattern is partitioned into the first data split when the third data pattern is read, and the partition of the first data split is determined to be complete, where the first data split is one of the multiple data splits.

The first data pattern may be a first type of data pattern in the first data split. The second data pattern may be a second type of data pattern in the first data split. The third data pattern may be the next data pattern that is different from the first data pattern and the second data pattern.

In the above embodiment, the third data pattern is partitioned into the first data split when the third data pattern is read, and the partition of the first data split is determined to be complete. It may be seen that, each of the multiple data splits includes at least one first data pattern, at least one second data pattern, and one third data pattern.

Exemplarily, each data pattern is assumed to include two-bit data. If binary data is 110010011110, the binary data is split in a manner that each data pattern includes two-bit data to obtain six data patterns, namely 11, 00, 10, 01, 11, 10. The six data patterns are scanned. The first 11 is a first data pattern that is read, and 00 is a second data pattern that is read. Therefore, 11 and 00 are partitioned into a first data split. 10 is partitioned into the first data split when 10, i.e. a third data pattern is read. Then, the partition of the first data split is determined to be complete, and the first data split 110010 is obtained.

It may be seen that, in the embodiment of the disclosure, the multiple data patterns are scanned, and the first data pattern and the second data pattern that are read are partitioned into the first data split; the third data pattern is partitioned into the first data split when the third data pattern is read, and the partition of the first data split is determined to be complete, which makes each of the multiple data splits include at least one first data pattern, at least one second data pattern, and one third data pattern. In this way, the data complexity of each data split is greatly reduced and that each data split is ensured to have a certain length. By simplifying the content of each data split and reducing the number of data splits, a reduction in the speed of data transmission caused by that the hard disk needs to spend time indexing a large number of data splits may be avoided, thereby improving the speed of data transmission.

In a possible embodiment, the multiple data patterns are partitioned to obtain the multiple data splits as follows. The multiple data patterns are scanned, and a first data pattern, a second data pattern, and a third data pattern that are read are partitioned into a first data split. A fourth data pattern is partitioned into the next data split when the fourth data pattern is read, and the partition of the first data split is determined to be complete, where the first data split is one of the multiple data splits.

In the above embodiment, the first data pattern, the second data pattern, and the third data pattern that are read are partitioned into the first data split. The fourth data pattern is partitioned into the next data split when the fourth data pattern is read, and the partition of the first data split is determined to be complete. It may be seen that, each of the multiple data splits includes at least one first data pattern, at least one second data pattern, and at least one third data pattern.

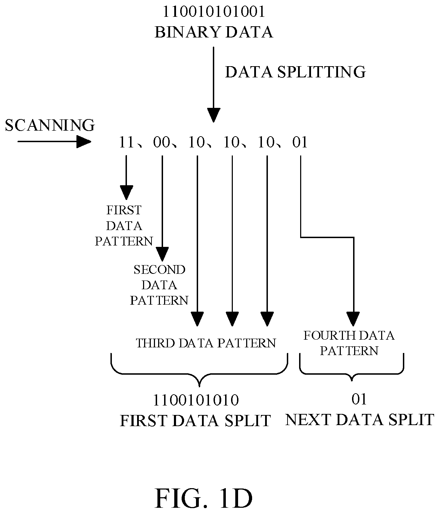

Exemplarily, reference is made to FIG. 1D, which is a schematic diagram of a method for data compression based on three data patterns provided in an embodiment of the disclosure. As illustrated in FIG. 1D, each data pattern is assumed to include two-bit data. If binary data is 110010101001, the binary data is split in a manner that each data pattern includes two-bit data to obtain six data patterns, namely 11, 00, 10, 10, 10,01. The six data patterns are scanned. 11 is a first data pattern that is read, 00 is a second data pattern that is read, and 10 is a third data pattern that is read. Therefore, 11, 00, 10, 10, and 10 are partitioned into a first data split. 01 is partitioned into the next data split when 01, i.e. a fourth data pattern is read. Then, the partition of the first data split is determined to be complete, and the first data split 1100101010 is obtained.

It may be seen that, in the embodiment of the disclosure, the multiple data patterns are scanned, and the first data pattern, the second data pattern, and the third data pattern that are read are partitioned into the first data split; the fourth data pattern is partitioned into the next data split when the fourth data pattern is read, and the partition of the first data split is determined to be complete, which makes each of the multiple data splits include at least one first data patter, at least one second data pattern, and at least one third data pattern. In this way, the data complexity of each data split is greatly reduced and that each data split is ensured to have a certain length. By simplifying the content of each data split and reducing the number of data splits, a reduction in the speed of data transmission caused by that the hard disk needs to spend time indexing a large number of data splits may be avoided, thereby improving the speed of data transmission.

In a possible embodiment, the binary data is split into the multiple data splits as follows. A data transmission duration of remaining data in the binary data is acquired when the partition of the N-th data split is complete. The remaining data is marked to obtain marked remaining data if the data transmission duration of the remaining data is less than or equal to a preset duration. The multiple data splits are abbreviated to obtain the multiple abbreviated data splits as follows. N data splits are abbreviated to obtain N abbreviated data splits. That the abbreviated data is sent, where the abbreviated data includes the multiple abbreviated data splits, is as follows. The abbreviated data is sent, where the abbreviated data includes the N abbreviated data splits and the marked remaining data.

The data transmission duration of the remaining data in the binary data is acquired when the partition of the N-th data split is complete. In specific embodiments, the data transmission duration of remaining data in the binary data is acquired whenever the partition of a data split is complete.

The preset duration may be 1ms or others.

The remaining data is marked to obtain the marked remaining data, so as to show that the remaining data is not abbreviated.

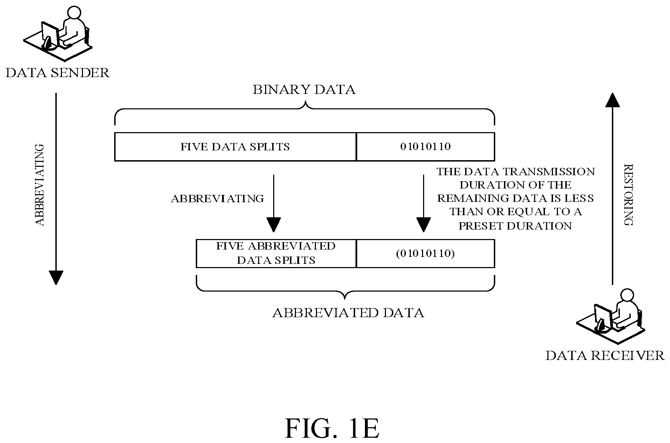

Exemplarily, it is assumed that N=5 and the preset duration is 1ms. Reference is made to FIG. 1E, which is a schematic diagram of a method for data compression based on three data patterns provided in another embodiment of the disclosure. As illustrated in FIG. 1E, when the partition of the 5th data split is complete, remaining data in the binary data is 01010110. A data transmission duration of 01010110 is acquired to be 0.5ms. It may be seen that the data transmission duration of the remaining data is less than the preset duration. Then, 01010110 is marked to obtain marked remaining data (01010110). As such, in the process of abbreviating multiple data splits, only the first five data splits are abbreviated to obtain five abbreviated data splits, and (01010110) will not be abbreviated. After the binary data is abbreviated, the data sender sends the five abbreviated data splits and also directly sends (01010110). In this example, when the data receiver receives the five abbreviated data splits and (01010110), where (01010110) is not included in the abbreviated data of the five abbreviated data splits, a restoring manner of (01010110) is to directly acquire 01010110 as a restored data split.

It may be seen that, in the embodiment of the disclosure, the data transmission duration of remaining data in the binary data is acquired when the partition of the N-th data split is complete; the remaining data is marked to obtain the marked remaining data if the data transmission duration of the remaining data is less than or equal to the preset duration; the abbreviated data including N abbreviated data splits and the marked remaining data is sent at the end. The data transmission duration of the remaining data is less than or equal to the preset duration, which indicates that the remaining data has a small data volume. In this case, if time is spent in abbreviating the remaining data, it may result in that a duration of abbreviating and sending the remaining data is longer than a duration of directly sending the remaining data. Therefore, the remaining data is directly sent without splitting and abbreviating. As can be seen, adopting the method provided in the embodiment of the disclosure will improve the speed of data transmission.

In a possible embodiment, the multiple data splits are abbreviated to obtain the multiple abbreviated data splits as follows. The first data pattern in each of the multiple data splits is transformed into a first abbreviated result, and the second data pattern in each of the multiple data splits is transformed into a second abbreviated result. The third data pattern in each of the multiple data splits is marked to obtain a marked third data pattern, and that the third data pattern in each of the multiple data splits is marked represents that the third data pattern has no corresponding abbreviated result. The multiple abbreviated data splits are determined, where each of the multiple abbreviated data splits consists of the first abbreviated result, the second abbreviated result, and the marked third data pattern.

The first abbreviated result may be 1 or other symbols, the second abbreviated result may be 0 or other symbols, and the first abbreviated result is different from the second abbreviated result.

In specific embodiments, the third data pattern in each of the multiple data splits may be marked with () or other marks.

Exemplarily, the first data pattern in each of the multiple data splits is transformed into the first abbreviated result, which means that the first data pattern in each of the multiple data splits is transformed into 1. The second data pattern in each of the multiple data splits is transformed into the second abbreviated result, which means that the second data pattern in each of the multiple data splits is transformed into 0. The third data pattern in each of the multiple data splits is marked with (). As illustrated in table 1, there is a binary data 1100101010011110, each data split is assumed to include three data patterns, and each data pattern is assumed to include two-bit data. Multiple data patterns are partitioned to obtain multiple data splits in the following manner. A first data pattern, a second data pattern, and a third data pattern that are read are partitioned into a first data split. A fourth data pattern is partitioned into the next data split when the fourth data pattern is read, and the partition of the first data split is determined to be complete. As can be seen from the above embodiment, the binary data 1100101010011110 may be split into data split 1, which is 1100101010, and data split 2, which is 011110. 11 of the data split 1 is the first data pattern of the data split 1 and 01 of the data split 2 is the first data pattern of the data split 2. 00 of the data split 1 is the second data pattern of the data split 1 and 11 of the data split 2 is the second data pattern of the data split 2. Likewise, 10 of the data split 1 is the third data pattern of the data split 1 and 10 of the data split 2 is the third data pattern of the data split 2. Therefore, 11 of the data split 1 is transformed into 1, 00 of the data split 1 is transformed into 0, and 10 of the data split 1 is marked. 01 of the data split 2 is transformed into 1, 11 of the data split 2 is transformed into 0, and 10 of the data split 2 is marked. Then, an abbreviated data split 1 is 10(101010), an abbreviated data split 2 is 10(10), and the abbreviation of these two data splits is complete. As can be seen, each abbreviated data split has a certain length due to the presence of the marked third data pattern. In this way, a reduction in the speed of data transmission caused by that the hard disk needs to spend time indexing a large number of data splits may be avoided. At the same time, since the length of each abbreviated data split is much shorter than the data split before being abbreviated, the speed of data transmission may be significantly improved.

**Table 1**

| | | Data split | First data pattern | | Second data pattern | | Third data pattern | | Abbreviated data split | |
|---|---|---|---|---|---|---|---|---|---|---|
| Data split 1 | | 1100101010 | | 11 | | 00 | | 10 | | 10 (101010) |
| Data split 2 | | 011110 | | 01 | | 11 | | 10 | | 10 (10) |

It may be seen that, in the embodiment of the disclosure, when the multiple data splits are abbreviated, the first data pattern in each of the multiple data splits is transformed into the first abbreviated result, and the second data pattern in each of the multiple data splits is transformed into the second abbreviated result; the third data pattern in each of the multiple data splits is marked to obtain the marked third data pattern, and that the third data pattern in each of the multiple data splits is marked represents that the third data pattern has no corresponding abbreviated result; the multiple abbreviated data splits are determined, where each of the multiple abbreviated data splits consists of the first abbreviated result, the second abbreviated result, and the marked third data pattern. In the method for data compression provided in embodiments of the disclosure, after binary conversion, splitting, and abbreviation, the original data is compressed into the abbreviated data including multiple abbreviated data splits, where each of the multiple abbreviated data splits includes three different data patterns. In this way, the data transmission volume is greatly reduced, and the efficiency of data transmission is improved.

In a possible embodiment, the multiple data splits are abbreviated to obtain the multiple abbreviated data splits as follows. The number of each of the three data patterns in each of the multiple data splits is acquired. A target data pattern to-be-marked is determined, where the target data pattern to-be-marked is a data pattern with the smallest number among the three data patterns. Two remaining data patterns other than the target data pattern to-be-marked in each of the multiple data splits are abbreviated to obtain a first abbreviated result and a second abbreviated result. The target data pattern to-be-marked in each of the multiple data splits is marked to obtain a marked data pattern. The multiple abbreviated data splits are determined, where each of the multiple abbreviated data splits consists of the first abbreviated result, the second abbreviated result, and the marked data pattern.

The two remaining data patterns other than the target data pattern to-be-marked in each of the multiple data splits are abbreviated to obtain the first abbreviated result and the second abbreviated result. In specific embodiments, a data pattern with the largest number among the three data patterns is transformed into the first abbreviated result, a data pattern with the number between the largest number and the smallest number among the three data patterns is transformed into the second abbreviated result, and vice versa.

The target data pattern to-be-marked is a data pattern with the smallest number among the three data patterns, and the target data pattern to-be-marked in each of the multiple data splits is marked to obtain the marked data pattern. In this way, each data split has a relatively small number of marked data patterns and a relatively large number of abbreviated data patterns.

Exemplarily, the first data pattern in each of the multiple data splits is transformed into the first abbreviated result, which means that the first data pattern in each of the multiple data splits is transformed into 1. The second data pattern in each of the multiple data splits is transformed into the second abbreviated result. If there is a data split 111100101010, the data split has three data patterns 11, 00 and 10. The number of the three data patterns 11, 00 and 10 are each obtained as 2, 1 and 3, respectively. Therefore, the number of the data pattern 10 > the number of the data pattern 11 > the number of the data pattern 00. The data pattern 00 with the smallest number among the three data patterns is determined as the target data pattern to-be-marked, the data pattern 10 with the largest number among the three data patterns is determined as the first data pattern, and the data pattern 11 with the number between the largest number and the smallest number among the three data patterns is determined as the second data pattern. The data pattern 10 is abbreviated into 1, the data pattern 11 is abbreviated into 0, and the data pattern 00 is marked. The abbreviated data split is determined as 00(00)111. In this example, the marked data pattern only has two-bit data. If the first type of data pattern 11 is determined as the first data pattern, the second type of data pattern 00 is determined as the second data pattern, and the third type of data pattern 10 is determined as the third data pattern, the data split 111100101010 will be abbreviated into 110(101010). It may be seen that, by adopting the method of the embodiment of the disclosure, the abbreviated data split may be prevented from having a relatively large number of marked data pattern, and the speed of data transmission may be improved by improving the compression effect of each data split.

It may be seen that, in the embodiment of the disclosure, when the multiple data splits are abbreviated, the number of each of the three data patterns in each of the multiple data splits is acquired; the data pattern with the smallest number among the three data patterns is determined as the target data pattern to-be-marked; two remaining data patterns other than the target data pattern to-be-marked in each of the multiple data splits are abbreviated to obtain the first abbreviated result and the second abbreviated result; the target data pattern to-be-marked in each of the multiple data splits is marked to obtain the marked data pattern; the multiple abbreviated data splits are determined, where each of the multiple abbreviated data splits consists of the first abbreviated result, the second abbreviated result, and the marked data pattern. By adopting the method for data compression provided in the embodiment of the disclosure, the number of the marked data patterns in each data split is relatively small and the number of the abbreviated data patterns is relatively large, which significantly improves the compression effect of each data split, thereby improving the speed of data transmission.

In a possible embodiment, the above method further includes the following. Multiple data dictionaries are generated according to the multiple data splits, where the multiple data dictionaries correspond to the multiple data splits in a one-to-one correspondence, and each of the multiple data dictionaries represents a data pattern corresponding to the first abbreviated result and a data pattern corresponding to the second abbreviated result in a corresponding data split. The multiple data dictionaries are sent, or multiple data dictionary indicators are sent, where the multiple data dictionary indicators correspond to the multiple data splits in a one-to-one correspondence, and a data dictionary indicator represents a data dictionary corresponding to a data split.

Each of the multiple data dictionaries represents a data pattern corresponding to the first abbreviated result and a data pattern corresponding to the second abbreviated result in a corresponding data split. In specific embodiments, each of the multiple data dictionaries may also represent a marking manner corresponding to the third data pattern, so that the data receiver can determine the third data pattern according to the data dictionary.

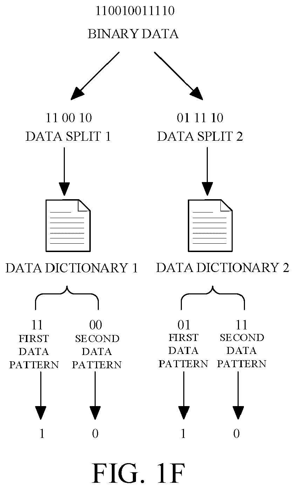

Exemplarily, reference is made to FIG. 1F, which is a schematic diagram of a method for data compression based on three data patterns provided in another embodiment of the disclosure. As illustrated in FIG. 1F, there is a binary data 110010011110, each data split includes three data patterns, and each data pattern includes two-bit data. A first data pattern is the first type of data pattern in each data split, and a second data pattern is the second type of data pattern in each data split. A first abbreviated result is 1, and a second abbreviated result is 0. As can be seen from the above embodiment, the binary data 110010011110 can be split into data split 1, which is 110010, and data split 2, which is 011110. 11 of the data split 1 is the first data pattern of the data split 1 and 01 of the data split 2 is the first data pattern of the data split 2. Likewise, 00 of the data split 1 is the second data pattern of the data split 1 and 11 of the data split 2 is the second data pattern of the data split 2. A data dictionary 1 corresponding to the data split 1 and a data dictionary 2 corresponding to the data split 2 are generated. The data dictionary 1 represents that the first abbreviated result corresponding to the first data pattern 11 of the data split 1 is 1 and the second abbreviated result corresponding to the second data pattern 00 of the data split 1 is 0. The data dictionary 2 represents that the first abbreviated result corresponding to the first data pattern 01 of the data split 2 is 1 and the second abbreviated result corresponding to the second data pattern 11 of the data split 2 is 0.

The multiple data dictionaries are sent, which means that the data sender directly sends the multiple data dictionaries to the data receiver when sending the abbreviated data, where the multiple data dictionaries correspond to the multiple data splits in a one-to-one correspondence. The multiple data dictionary indicators are sent, which means that the data sender only sends the multiple data dictionary indicators to the data receiver when sending the abbreviated data, where a data dictionary indicator represents a data dictionary corresponding to a data split, and the multiple data dictionary indicators correspond to the multiple data splits in a one-to-one correspondence.

In specific embodiments, the data transmission volume of sending the multiple data dictionary indicators is smaller than the data transmission volume of directly sending the multiple data dictionaries. If the data receiver locally stores the multiple data dictionaries, the speed of data transmission may be further improved by sending the multiple data dictionary indicators.

It may be seen that, in the embodiment of the disclosure, the multiple data dictionaries are generated according to multiple data splits, where the multiple data dictionaries correspond to the multiple data splits in a one-to-one correspondence, and each of the multiple data dictionaries represents a data pattern corresponding to the first abbreviated result and a data pattern corresponding to the second abbreviated result in a corresponding data split; the multiple data dictionaries are sent, or the multiple data dictionary indicators are sent, where a data dictionary indicator represents a data dictionary corresponding to a data split. In this way, the data receiver is informed about restoring manners corresponding to the multiple abbreviated data splits included in the abbreviated data, so that the data receiver may restore the abbreviated data according to the multiple data dictionaries to obtain the original data.

In a possible embodiment, the above method also includes the following. A first sub-split is determined from a (first) abbreviated data split, where the first sub-split includes a first abbreviated result and a second abbreviated result of the abbreviated data split. Whether the first sub-split is the same as the third data pattern is detected. The abbreviated data split is abbreviated again to obtain a further abbreviated data split if the first sub-split is the same as the third data pattern.

The first sub-split may include one first abbreviated result and one second abbreviated result, or may include all the remaining two types of abbreviated results other than the third data pattern in the abbreviated data split.

Exemplarily, the first sub-split includes one first abbreviated result and one second abbreviated result. The first abbreviated result is 1, and the second abbreviated result is 0. A (first) abbreviated data split is 10(10), and the first sub-split includes the first abbreviated result 1 and the second abbreviated result 0 of the abbreviated data split. The third data pattern is 10. Therefore, the first sub-split is detected to be the same as the third data pattern. Then, 10 is determined as the first data pattern of the abbreviated data split, and the first data pattern 10 is abbreviated into 1. In this way, the abbreviated data split 10(10) is abbreviated to obtain a further abbreviated data split 11.

It may be seen that, in the embodiment of the disclosure, the first sub-split is determined from the (first) abbreviated data split, where the first sub-split includes the first abbreviated result and the second abbreviated result of the abbreviated data split; whether the first sub-split is the same as the third data pattern is detected; the abbreviated data split is abbreviated to obtain the further abbreviated data split if the first sub-split is the same as the third data pattern. By compressing the data split for multiple times, the compression effect of the data split is significantly improved, and the speed of data transmission is further improved.

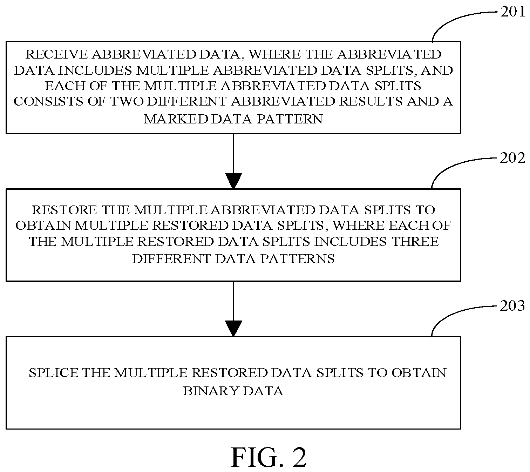

The embodiment illustrated in FIG. 1B is applied in the data sender. For the data receiver, an embodiment of the disclosure provides a method for data decompression based on three data patterns. Reference is made to FIG. 2, which is a flowchart of a method for data decompression based on three data patterns provided in an embodiment of the disclosure. As illustrated in FIG. 2, the method includes the following operations.

At 201, abbreviated data is received, where the abbreviated data includes multiple abbreviated data splits, and each of the multiple abbreviated data splits consists of two different abbreviated results and a marked data pattern.

At 202, the multiple abbreviated data splits are restored to obtain multiple restored data splits, where each of the multiple restored data splits includes three different data patterns.

At 203, the multiple restored data splits are spliced to obtain binary data.

It may be seen that, in the embodiment of the disclosure, the abbreviated data is received, where the abbreviated data includes the multiple abbreviated data splits, and each of the multiple abbreviated data splits consists of two different abbreviated results and the marked data pattern; the multiple abbreviated data splits are restored to obtain the multiple restored data splits, where each of the multiple restored data splits includes three different data patterns; the multiple restored data splits are spliced to obtain the binary data. By adopting the method for data decompression of the embodiment of the disclosure, the multiple abbreviated data splits including two different abbreviated results and the marked data patterns are restored and spliced to obtain the binary data at the end. The origin of the data is restored through data decompression, and the process of data decompression is ensured to cause no damage on the data by using a given restoring method.

In a possible embodiment, the above method also includes the following. When the data received is the marked data pattern and the marked data pattern is not included in the multiple abbreviated data splits, the marked data pattern is acquired as a restored data split.

In specific embodiments, the marked data pattern is not included in the multiple abbreviated data splits, which indicates that the marked data pattern has no corresponding data dictionary.

In specific embodiments, the marked data pattern is acquired as a restored data split, which may be that the mark of the marked data pattern is removed to obtain a restored data split.

It may be seen that, in the embodiment of the disclosure, when the data received is the marked data pattern and the marked data pattern is not included in the multiple abbreviated data splits, the marked data pattern is acquired as a restored data split. By directly acquiring the marked data pattern not included in the multiple abbreviated data splits as a restored data split, the speed of restoring may be improved while the data decompression is ensured to be able to restore the origin of the data.

In a possible embodiment, the multiple abbreviated data splits are restored to obtain the multiple restored data splits as follows. Each of the multiple abbreviated data splits is restored according to a data dictionary corresponding to each of the multiple abbreviated data splits, to obtain multiple restored data splits. A data dictionary represents data patterns corresponding to the two different abbreviated results.

It may be seen that, in the embodiment of the disclosure, each of the multiple abbreviated data splits is restored according to a data dictionary corresponding to each of the multiple abbreviated data splits, to obtain multiple restored data splits. In this way, the data receiver can restore the abbreviated data according to the data dictionaries to obtain the original data. With the data dictionaries as an evidence for data restoration, each abbreviated data split may be restored according to a data dictionary, which not only improves the speed of data decompression, but also further ensures that the origin of the data is restored to the maximum extent possible during the process of data decompression without causing data damage.

In a possible embodiment, the abbreviated data is received as follows. A data dictionary corresponding to each abbreviated data split is received, or a data dictionary indicator corresponding to each abbreviated data split is received, where the data dictionary indicator is used to acquire a data dictionary stored locally.

It may be seen that, in the embodiment of the disclosure, in terms of receiving abbreviated data, a data dictionary corresponding to each abbreviated data split is received, or a data dictionary indicator corresponding to each abbreviated data split is received, in order to acquire data dictionaries stored locally. In this way, the data receiver may restore the abbreviated data according to the data dictionaries to obtain the original data.

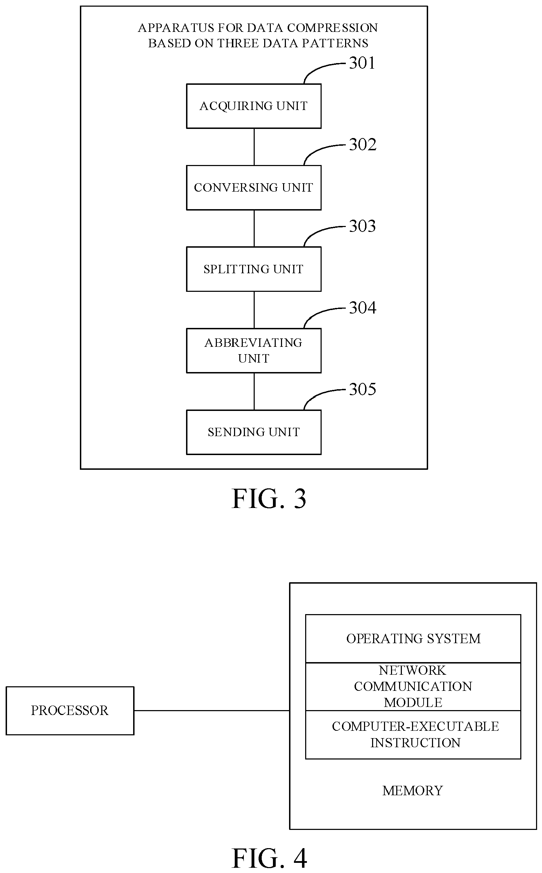

Consistent with the embodiment of the FIG. 1B, reference is made to FIG. 3, which is a structural diagram of an apparatus for data compression based on three data patterns provided in an embodiment of the disclosure. As illustrated in FIG. 3, the apparatus for data compression based on three data patterns includes an acquiring unit 301, a conversing unit 302, a splitting unit 303, an abbreviating unit 304, and a sending unit 305.

The acquiring unit 301 is configured to acquire original data. The conversing unit 302 is configured to perform a binary conversion on the original data to obtain binary data. The splitting unit 303 is configured to split the binary data into multiple data splits, where each of the multiple data splits includes three different data patterns. The abbreviating unit 304 is configured to abbreviate the multiple data splits to obtain multiple abbreviated data splits. The sending unit 305 is configured to send abbreviated data, where the abbreviated data includes the multiple abbreviated data splits.

It may be seen that, in the apparatus provided in the embodiment of the disclosure, the acquiring unit 301 is configured to acquire original data; the conversing unit 302 is configured to perform a binary conversion on the original data to obtain binary data; the splitting unit 303 is configured to split the binary data into multiple data splits, where each of the multiple data splits includes three different data patterns; the abbreviating unit 304 is configured to abbreviate the multiple data splits to obtain multiple abbreviated data splits; and the sending unit 305 is configured to send the abbreviated data, where the abbreviated data includes the multiple abbreviated data splits. By adopting the apparatus for data compression provided in the embodiment of the disclosure, after binary conversion, splitting, and abbreviation, the original data is compressed into the abbreviated data including multiple abbreviated data splits, where each of the multiple abbreviated data splits includes three different data patterns. In this way, the data transmission volume is greatly reduced, and the efficiency of data transmission is improved.

Specifically, in the embodiment of the disclosure, functional units of the apparatus for data compression based on three data patterns may be divided according to the above method. For example, functional units may be divided into different functional units according to different functions, or two or more functions may be integrated in one processing unit. The integrated unit may be implemented in a form of hardware, or may be implemented in a form of a software functional unit. It should be noted that, division of the units in the embodiment of the disclosure is an example, and is merely logical function division. In actual implementation, another division manner may be used.

Consistent with the above embodiment of FIG. 1B, an electronic device is provided in the embodiment of the disclosure. Reference is made to FIG. 4, which is a schematic structural diagram of a server serving as hardware operating environment of an electronic device provided in an embodiment of the disclosure. As illustrated in FIG. 4, the electronic device includes a processor, a memory, and a computer-executable instruction that is stored in the memory and executable on the processor. The computer-executable instruction, when executed, causes the electronic device to execute instructions including any steps of the method for data compression based on three data patterns.

The processor is a central processing unit (CPU).

Optionally, the memory can be a high-speed random-access memory (RAM), or can be a non-transitory memory. For example, the memory is a magnetic disk storage.

Those of ordinary skills in the art may understand that the server structure illustrated in FIG. 4 does not constitute any limitation on the server. The server may further include components more or fewer than those shown in the figure, or in the server, some components are combined, or the components are disposed differently.

As illustrated in FIG. 4, the memory may include an operating system, a network communication module, and a computer-executable instruction of the method for data compression based on three data patterns. The operating system is configured to manage and control server hardware and software resources, supporting the execution of the computer-executable instruction. The network communication module is configured to realize the communication between various components inside the memory, as well as communication between other hardware and software inside the server. The communication may use any communication standard or protocol, including but not limited to global system of mobile communication (GSM), general packet radio service (GPRS), code division multiple access 2000 (CDMA2000), wideband code division multiple access (WCDMA), time division synchronous code division multiple access (TD-SCDMA), and the like.

In the server illustrated in FIG. 4, the processor is configured to execute the personnel-managed computer-executable instruction stored in the memory, in order to realize the following.

Specific embodiments of the servers involved in the disclosure can be found in various embodiments of the method for data compression based on three data patterns described above, which will not be repeated herein.

Embodiments of the disclosure provide a computer-readable storage medium. The computer-readable storage medium stores a computer instruction, and the computer instruction, when executed on a communication device, causes the communication device to execute the following.

The electronic device may be a mobile phone, a tablet, a personal digital assistant, a wearable device, etc.

The computer-readable storage medium may be an internal storage unit of the electronic device in the above embodiment, for example, a hard disk or a memory of the electronic device. The computer-readable storage medium may also be an external storage device of the electronic device, such as a plug-in hard drive, a smart media card (SMC), a secure digital (SD) card, a flash card, etc. Furthermore, the computer-readable storage medium may include both an internal storage unit of the electronic device and an external storage device. The computer-readable storage medium is used to store computer-executable instructions and other computer-executable instructions and data required by the electronic device. The computer-readable storage medium can also be used to temporarily store data that has been output or will be output.

The specific embodiment of the computer-readable storage medium involved in the disclosure can be referred to the embodiments of the method for data compression based on three data patterns described above, which will not be repeated herein.

Embodiments of the disclosure provide a computer program product. The computer program product includes a computer program, which is operable to cause a computer to perform some or all of the steps in any method for data compression based on three data patterns in the above method embodiments. The computer program product may be a software installation package.

It should be noted that, for any embodiments of the above method for data compression based on three data patterns, the steps are described as a series of action combinations for ease of description, but those of ordinary skills in the art should know that, the present invention is not limited by a sequence of described actions. Secondly, those of ordinary skills in the art should also know that, the embodiments described in the specification are preferred embodiments, and the involved actions are not necessarily needed by the embodiments of the present invention.

The embodiments of the disclosure are described in details. The principles and embodiments of the disclosure, which is a method for data compression based on three data patterns and a method for data decompression based on three data patterns, are described through specific examples. The description of the above embodiments is for the purposes to understand the method and core ideas of the present disclosure. Those of ordinary skills in the art may perform modification on the specific embodiments and the scope of application based on the idea of the disclosure, which is a method for data compression based on three data patterns and a method for data decompression based on three data patterns. In summary, content of the present specification should not be construed as limiting the present disclosure.

The present disclosure is described with reference to the flowcharts and/or block diagrams of the method, the hardware products, and the computer program product according to the embodiments of the present disclosure. It should be understood that computer program instructions may be used to implement each process and/or each block in the flowcharts and/or the block diagrams and a combination of a process and/or a block in the flowcharts and/or the block diagrams. These computer program instructions may be provided for a general-purpose computer, a dedicated computer, an embedded processor, or a processor of any other programmable data processing device to generate a machine, so that the instructions executed by a computer or a processor of any other programmable data processing device generate an apparatus for implementing a specific function in one or more processes in the flowcharts and/or in one or more blocks in the block diagrams.

These computer program instructions may also be stored in a computer-readable memory that can instruct the computer or any other programmable data processing device to work in a specific manner, so that the instructions stored in the computer-readable memory generate an artifact that includes an instruction apparatus. The instruction apparatus implements a specific function in one or more processes in the flowcharts and/or in one or more blocks in the block diagrams. The memory may include a flash drive, a read only memory (ROM), a random access memory (RAM), a magnetic disk, an optical disk, etc.

Although the disclosure is described with reference to the embodiments, in a process of implementing the disclosure that claims protection, those of ordinary skills in the art may understand and implement another variation of the disclosed embodiments by viewing the accompanying drawings, disclosed content, and the accompanying claims. In the claims, "comprising" does not exclude another component or another step, and "a" or "one" does not exclude a case of multiple. A single processor or another unit may implement several functions enumerated in the claims. The fact that some measures are recorded in mutually different dependent claims does not indicate that a combination of these measures cannot bring better effects.

It may be understood by those of ordinary skills in the art that some or all of the steps of the various methods of the embodiments of the method for data compression based on three data patterns and the method for data decompression based on three data patterns described above may be accomplished by means of a program to instruct associated hardware. The program may be stored in a computer-readable memory, which may include a flash memory, a ROM, a RAM, a magnetic disk, an optical disk, etc.

Obviously, those of ordinary skills in the art can make various modifications and variations to the disclosure, which is a method for data compression based on three data patterns and a method for data decompression based on three data patterns, without departing from the spirit and scope of the disclosure. The disclosure is intended to cover these modifications and variations of the disclosure provided that they fall within the scope of protection defined by the following claims and their equivalent technologies.

## Claims

1. A method for data compression based on three data patterns, comprising:
acquiring original data;
performing a binary conversion on the original data to obtain binary data;
splitting the binary data into a plurality of data splits, wherein each of the plurality of data splits comprises three different data patterns;
abbreviating the plurality of data splits to obtain a plurality of abbreviated data splits; and
sending abbreviated data, wherein the abbreviated data comprises the plurality of abbreviated data splits.

2. The method of claim 1, wherein splitting the binary data into the plurality of data splits comprises:
splitting the binary data to obtain a plurality of data patterns, wherein each of the plurality of data patterns comprises n-bit data; and
partitioning the plurality of data patterns to obtain the plurality of data splits, wherein each of the plurality of data splits comprises three data patterns.

3. The method of claim 2, wherein partitioning the plurality of data patterns to obtain the plurality of data splits comprises:
scanning the plurality of data patterns, and partitioning a first data pattern and a second data pattern that are read into a first data split; and
partitioning a third data pattern into the first data split in response to the third data pattern being read, and determining that a partition of the first data split is complete, wherein the first data split is one of the plurality of data splits.

4. The method of claim 2, wherein partitioning the plurality of data patterns to obtain the plurality of data splits comprises:
scanning the plurality of data patterns, and partitioning a first data pattern, a second data pattern, and a third data pattern that are read into a first data split; and
partitioning a fourth data pattern into a next data split in response to the fourth data pattern being read, and determining that a partition of the first data split is complete, wherein the first data split is one of the plurality of data splits.

5. The method of any one of claims 2-4, wherein splitting the binary data into the plurality of data splits comprises:
acquiring a data transmission duration of remaining data in the binary data in response to a partition of an N-th data split being complete; and
marking the remaining data to obtain marked remaining data if the data transmission duration of the remaining data is less than or equal to a preset duration;
wherein abbreviating the plurality of data splits to obtain the plurality of abbreviated data splits comprises:
abbreviating N data splits to obtain N abbreviated data splits;
wherein sending the abbreviated data, wherein the abbreviated data comprises the plurality of abbreviated data splits, comprises:
sending the abbreviated data, wherein the abbreviated data comprises the N abbreviated data splits and the marked remaining data.

6. The method of claim 3 or 4, wherein abbreviating the plurality of data splits to obtain the plurality of abbreviated data splits comprises:
transforming the first data pattern in each of the plurality of data splits into a first abbreviated result, and transforming the second data pattern in each of the plurality of data splits into a second abbreviated result;
marking the third data pattern in each of the plurality of data splits to obtain a marked third data pattern, wherein marking the third data pattern in each of the plurality of data splits represents that the third data pattern has no corresponding abbreviated result; and
determining the plurality of abbreviated data splits, wherein each of the plurality of abbreviated data splits consists of the first abbreviated result, the second abbreviated result, and the marked third data pattern.

7. The method of claim 4, wherein abbreviating the plurality of data splits to obtain the plurality of abbreviated data splits comprises:
acquiring a number of each of the three data patterns in each of the plurality of data splits;
determining a target data pattern to-be-marked, wherein the target data pattern to-be-marked is a data pattern with the smallest number among the three data patterns;
abbreviating two remaining data patterns other than the target data pattern to-be-marked in each of the plurality of data splits to obtain a first abbreviated result and a second abbreviated result;
marking the target data pattern to-be-marked in each of the plurality of data splits to obtain a marked data pattern; and
determining the plurality of abbreviated data splits, wherein each of the plurality of abbreviated data splits consists of the first abbreviated result, the second abbreviated result, and the marked data pattern.

8. The method of claim 6 or 7, further comprising:
generating a plurality of data dictionaries according to the plurality of data splits, wherein the plurality of data dictionaries correspond to the plurality of data splits in a one-to-one correspondence, and each of the plurality of data dictionaries represents a data pattern corresponding to the first abbreviated result and a data pattern corresponding to the second abbreviated result in a corresponding data split; and
sending the plurality of data dictionaries; or
sending a plurality of data dictionary indicators, wherein the plurality of data dictionary indicators correspond to the plurality of data splits in a one-to-one correspondence, and a data dictionary indicator represents a data dictionary corresponding to a data split.

9. A method for data decompression based on three data patterns, comprising:
receiving abbreviated data, wherein the abbreviated data comprises a plurality of abbreviated data splits, and each of the plurality of abbreviated data splits consists of two different abbreviated results and a marked data pattern;
restoring the plurality of abbreviated data splits to obtain a plurality of restored data splits, wherein each of the plurality of restored data splits comprises three different data patterns; and
splicing the plurality of restored data splits to obtain binary data.

10. The method of claim 9, further comprising:
acquiring a marked data pattern as a restored data split in response to the marked data pattern being received and the marked data pattern being not comprised in the plurality abbreviated data splits.
